# EUROPEAN PATENT APPLICATION

(11) **EP 2 073 253 A1**
(43) Date of publication of application: **24.06.2009**
(21) Application number: 07829673.8
(22) Date of filing: 12.10.2007
(51) Int. Cl.: H01L 21/3065, B01J 19/08, H01L 21/31, C23C 16/455

(54) **METHOD FOR MANUFACTURING ELECTRONIC DEVICE USING PLASMA REACTOR PROCESSING SYSTEM**

(30) Priority: 13.10.2006 JP 2006280263; 13.10.2006 JP 2006280275
(71) Applicant: Omron Corporation, Kyoto-shi, Kyoto 600-8530 (JP); Tohoku University, Aoba-ku Sendai-shi Miyagi 980-8577 (JP)
(72) Inventor: INOUE, Yoshinori, c/o OMRON CORPORATION, Kyoto-shi Kyoto 6008530 (JP); MORISHITA, Sadaharu, c/o OMRON CORPORATION, Kyoto-shi Kyoto 6008530 (JP); OHMI, Tadahiro, c/o TOHOKU UNIVERSITY, Sendai-shi Miyagi 9808577 (JP)
(74) Representative: Wilhelms · Kilian & Partner Patentanwälte
(86) International application number: PCT/JP2007/069937
(87) International publication number: WO 2008/047704

(57) **Abstract**

To enable change of a concentration of atmosphere in a process chamber and realize a plasma reaction process required for manufacturing a liquid crystal device and a semiconductor device with a high yield at a low cost.

A new flow rate setting value given to a pressure control type flow rate adjusting device of each constituent gas is a value obtained by calculating back from the process gas concentration after an estimated change under the condition that the total flow rate value is identical before and after the concentration change. A pressure controller of an exhaust pipe is switched from a pressure setting mode to a valve open setting mode only for a predetermined small time from the modification start and receives a valve open setting value obtained experimentally so as to mitigate the pressure fluctuation immediately after the change.

## Description

### TECHNICAL FIELD

The present invention relates to a method for manufacturing an electronic device using a plasma reactor processing system suited for manufacturing an electronic device such as a liquid crystal device and a semiconductor device.

### BACKGROUND ART

This type of plasma reactor processing system includes a process chamber incorporating a plasma generator (e.g., parallel plate electrode type, microwave antenna type, etc.); a supply pipe of an inactive gas for connecting each of one type or two or more types of inactive gas source (e.g., Ar, Kr, Xe, etc.) and the process chamber; a supply pipe of process gas for connecting each of one type or two or more types of process gas source (e.g., H2, O2, NF3, CL2, SiCl4, HBr, SF6, C5F8, CF4, etc.) and the process chamber; and an exhaust pipe of an in-chamber gas for connecting the process chamber and an exhaust pump.

The supply pipe of each inactive gas and each process gas is interposed with a flow rate adjusting device capable of adjusting the flow rate of the gas flowing through the pipe to a set value, and the exhaust pipe of the in-chamber gas is interposed with a pressure controller having a function of automatically changing the opening of a flow rate control valve in a direction of decreasing a deviation between a given pressure setting value and a pressure measurement value measured through a pressure measurement unit.

In this type of plasma reactor processing system, the concentration of the atmosphere in the process chamber needs to be changed at the start of the process, in the middle of the process, and at the end of the process. For example, at the start of the process, the concentration change from a single atmosphere of inactive gas (diluted gas) to a mixed atmosphere of the inactive gas and one type or two or more types of process gas is required. In the middle of the process, the concentration change from the mixed atmosphere of a certain concentration of the inactive gas and the process gas to a mixed atmosphere of a different concentration or a mixed atmosphere of different types of gas is sometimes required. At the end of the process, the concentration change from the mixed atmosphere of the inactive gas and the process gas to the single atmosphere of inactive gas is required.

Generally, the change in concentration is realized by giving a new flow rate setting value to the flow rate adjusting device interposed in the supply pipe of each constituent gas. Conventionally, the flow rate adjusting device used for such a purpose has a problem in that quite a long period is required until the pressure in the process chamber stabilizes since the temperature distribution type in which excessive flow rate tends to occur immediately after the start of gas supply is adopted.

Such a problem is solved by adopting the pressure control type flow rate adjusting device for the flow rate adjusting device (see patent document 1). In other words, the pressure control type flow rate adjusting device has a function of automatically changing the opening of the flow rate control valve in a direction of decreasing the deviation between the given flow rate setting value and the flow rate detection value corresponding to the fluid pressure measured through the pressure measurement unit, where the flow rate of the flow rate setting value is obtained from immediately after the start of gas supply.

On the other hand, even if the pressure control type flow rate adjusting device is adopted for the flow rate adjusting device, a problem in that a relatively large pressure fluctuation occurs in the process chamber arises even when the pressure controller is interposed in the exhaust pipe of the in-process chamber gas if a new flow rate setting value is given to the flow rate adjusting device of each constituent gas to change the flow rate.

Such a problem is solved by instantly changing (increasing) the exhaust amount in conjunction with the change in flow rate by the pressure control type flow rate adjusting device by an opening variable type fluid control valve or an exhaust speed variable type exhaust pump interposed in the exhaust pipe of the in-process chamber gas (see patent document 2).
Patent document 1: Japanese Unexamined Patent Publication No. 2000-200780
Patent document 2: Japanese Unexamined Patent Publication No. 2002-203795

### DISCLOSURE OF THE INVENTION

### PROBLEMS TO BE SOLVED BY THE INVENTION

However, even with the method for manufacturing the electronic device using the plasma reactor processing system described in patent document 2, the pressure fluctuation in the process chamber caused by the change in flow rate by the pressure control type adjusting device cannot be completely absorbed even by instantly changing the exhaust amount in conjunction with the change in flow rate by the pressure control type flow rate adjusting device as the easiness to flow and easiness to exhaust differ depending on each type of gas.

The present invention focuses on the above-described problems, and aims to provide a method for manufacturing an electronic device using a plasma reactor processing system capable of instantly changing the concentration of the atmosphere in the process chamber at the start of the process, in the middle of the process, and at the end of the process, and realizing at high productivity and low cost the plasma reaction process necessary for producing the liquid crystal device and the semiconductor device.

Other objects and advantages of the invention may be easily recognized by those skilled in the art by reference to the following description of the specification.

### MEANS FOR SALVING THE PROBLEMS

The problems to be solved by the invention are solved by the method for manufacturing the electronic device using the plasma reactor processing system having the following configuration.

Specifically, a plasma reactor processing system used in a method for manufacturing an electronic device includes: a process chamber (plasma reactor body) incorporating a plasma generator; a supply pipe of an inactive gas for connecting each of one type or two or more types of inactive gas source and the process chamber; a supply pipe of a process gas for connecting each of one type or two or more types of process gas source and the process chamber; and an exhaust pipe of an in-chamber gas for connecting the process chamber and an exhaust pump.

According to the present invention, in the plasma reactor processing system, the method includes: the first step of giving a new flow rate setting value to the pressure control type flow rate adjusting device interposed on the supply pipe of each constituent gas for changing a concentration of the process gas in the process chamber; wherein in the first step, each new flow rate setting value given to each of the flow rate adjusting device is a value obtained by calculating back from a process gas concentration after an estimated change under a condition that a total flow rate value is identical with each other between before and after the change in concentration.
Further, the exhaust pipe of the in-chamber gas is interposed with a pressure controller having a first operation mode of automatically changing the opening of the flow rate control valve in a direction of decreasing a deviation between a given pressure setting value and a pressure measurement value measured by the pressure measurement unit.

According to such a configuration, in changing the concentration of the process gas, the new flow rate setting value given to the flow rate adjusting device interposed in the supply pipe of each constituent gas is a value obtained by calculating back from the process gas concentration after the estimated change under the condition that the total flow rate value is identical before and the change in concentration, and thus even if the flow rate is changed by the flow rate adjusting device interposed in the supply path of each constituent gas, the pressure fluctuation does not occur in the process chamber or even if the pressure fluctuation does occur, it is held at a very small value as the change in flow rate cancels out. Thus, if the pressure fluctuation is of such an extent, the pressure controller interposed in the exhaust pipe of the in-chamber gas operates to immediately stabilize the fluctuation of the pressure in the chamber.

In a preferred embodiment, in the first step, limiting to a predetermined first period from start of change, each of the new flow rate setting value given to each of the flow rate adjusting device is added with an exceeding amount in a decreasing direction for a constituent gas that decreases after the change and an exceeding amount in an increasing direction for a constituent gas that increases after the change, and a total exceeding amount in the decreasing direction and a total exceeding amount in the increasing direction are set to be identical with each other. In this case, the first period is preferably smaller than or equal to two seconds.

According to such a configuration, limiting to a predetermined short period from the modification start, the flow rate value by each flow rate adjusting device is increased beyond the increase target value, which is the target, or decreased beyond the decrease target value, which is the target, and thus, the concentration of the atmosphere in the process chamber rapidly reaches the target concentration from the start of modification of the concentration and thereafter stabilizes even if the capacity of the process chamber is relatively large. Furthermore, since the total exceeding amount in the decreasing direction and the total exceeding amount in the increasing direction are set to be identical with each other even in the period the flow rate is in excess, the total exceeding amounts cancel out and do not contribute to pressure fluctuation.

In a further preferred embodiment of the present invention, the pressure controller interposed in the exhaust pipe of the in-chamber gas further has a second operation mode of automatically changing the opening of the flow rate control valve in a direction of decreasing a deviation between a given open setting value and a current open value, and the method further include: the second step of, limiting to a predetermined second period from the start of the change, switching the pressure controller interposed in the exhaust pipe from the first operation mode to the second operation mode, and giving a valve open setting value obtained experimentally to mitigate a pressure fluctuation immediately after the change. In this case, the second period is preferably smaller than or equal to three seconds

According to such a configuration, when pressure fluctuation occurs in the chamber due to the difference in easiness in flow and easiness in exhaustion of each type of gas even if the new flow rate setting value given to the flow rate adjusting device interposed in the supply pipe of each constituent gas is a value obtained by calculating back from the process gas concentration after the estimated change under the condition the total flow rate value is identical before and after concentration change, the pressure controller interposed in the exhaust pipe is switched from the first operation mode to the second operation mode limited to a predetermined short period from the modification start, and the valve open setting value obtained experimentally is given to mitigate the pressure fluctuation of immediately after the change, so that the pressure fluctuation originating from the gas type is mitigated by having valve opening instantly following thereto.

As an obvious feature of the manufacturing device according to the present invention, the change in concentration of the process gas is applicable to any of the change in concentration of the process gas at the start of the process, in the middle of the process, or at the end of the process.

In the present invention, the utilization efficiency of the process gas enhances and the manufacturing cost lowers by that much as the process gas introduced into the reactor is immediately plasmatized and contributed to the plasma reaction process. In addition, the waiting period before the start of the reaction process can be greatly reduced, whereby the productivity enhances by the reduction in the TAT (Turn-Around Time) of the process.

The supply of process gas is immediately stopped with the completion of the plasma reaction process, and thereafter, the plasma generation stop command to the plasma generator is rapidly given, and thus the process gas that does not contribute to plasma reaction is prevented from being wastefully used, and the manufacturing cost can be lowered through enhancement of the utilization efficiency of the process gas.

As the waiting period after the termination of the reaction process can also be greatly reduced, the productivity alto enhances by the reduction of the TAT (Turn-Around Time) of the process.

In addition to the supplied process gas immediately contributing to the plasma reaction process, the power is not wastefully consumed in starting the plasma reaction process, whereby the productivity enhances and the process gas can be saved, and in addition, lower cost can be pursued to the maximum by saving power energy.

Furthermore, as the supply of process gas is stopped with the cutting of the power and the termination of the plasma reaction process, the process gas is not wastefully consumed, whereby the productivity enhances and the process gas can be saved, and in addition, lower cost can be pursued to the maximum by saving power energy.

### EFFECTS OF THE INTENTION

According to the present invention, in changing the concentration of the process gas, the new flow rate setting value given to the flow rate adjusting device interposed in the supply pipe of each constituent gas is a value obtained by calculating back from the process gas concentration after the estimated change under the condition that the total flow rate value is identical before and the change in concentration, and thus even if the flow rate is changed by the flow rate adjusting device interposed in the supply path of each constituent gas, the pressure fluctuation does not occur in the process chamber or even if the pressure fluctuation does occur, it is held at a very small value as the change in flow rate cancels out. Thus, if the pressure fluctuation is of such an extent, the pressure controller interposed in the exhaust pipe of the in-chamber gas operates to immediately stabilize the fluctuation of the pressure in the chamber.

### BRIEF DESCRIPTION OF THE DRAWINGS

Fig. 1 is an overall configuration view of a plasma reactor processing system.
Fig. 2 is a schematic configuration view of an FCS and an APC.
Fig. 3 is a view showing a configuration view of a plasma generator.
Fig. 4 is an explanatory view (I) of a concentration changing control at start of process.

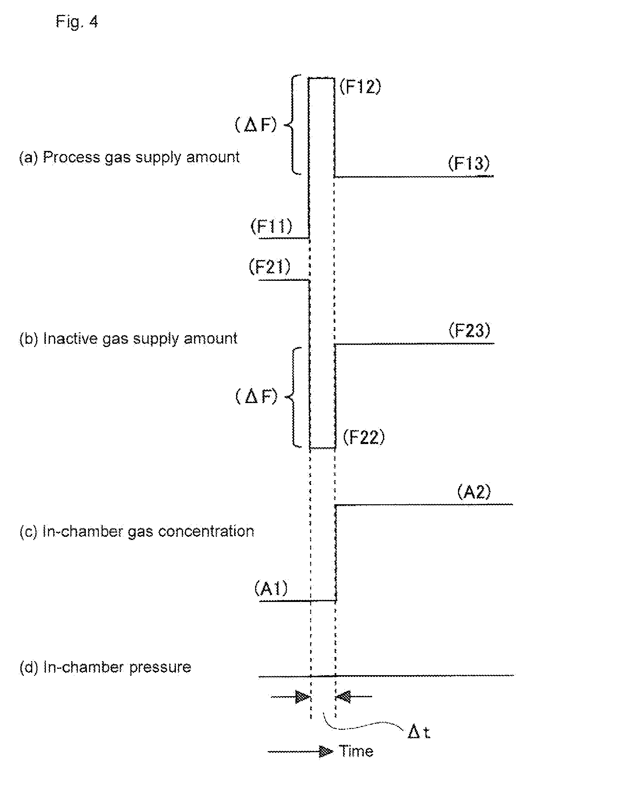

Fig. 4 is an explanatory view (II) of a concentration changing control at start of process.

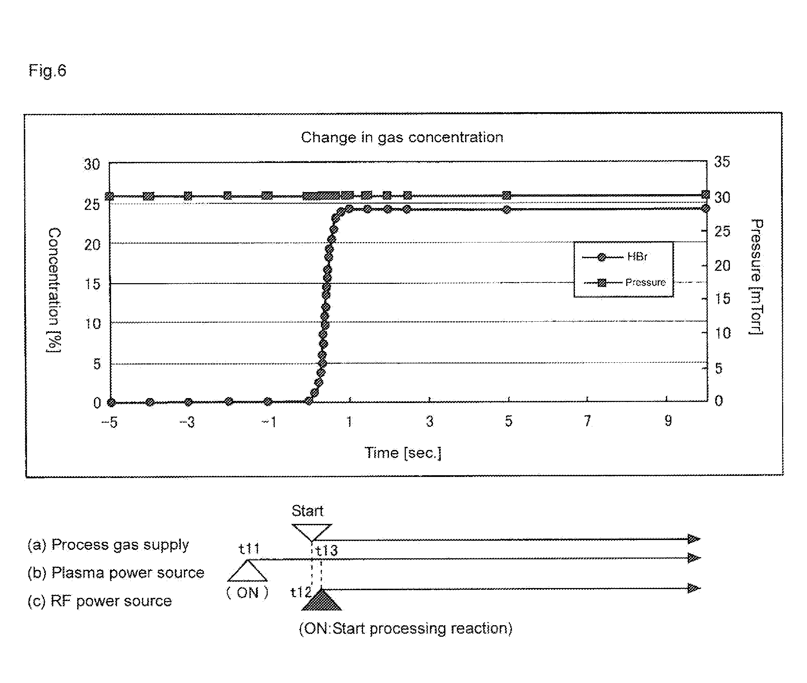

Fig. 6 is a view showing change in gas concentration when using the method of the present invention.

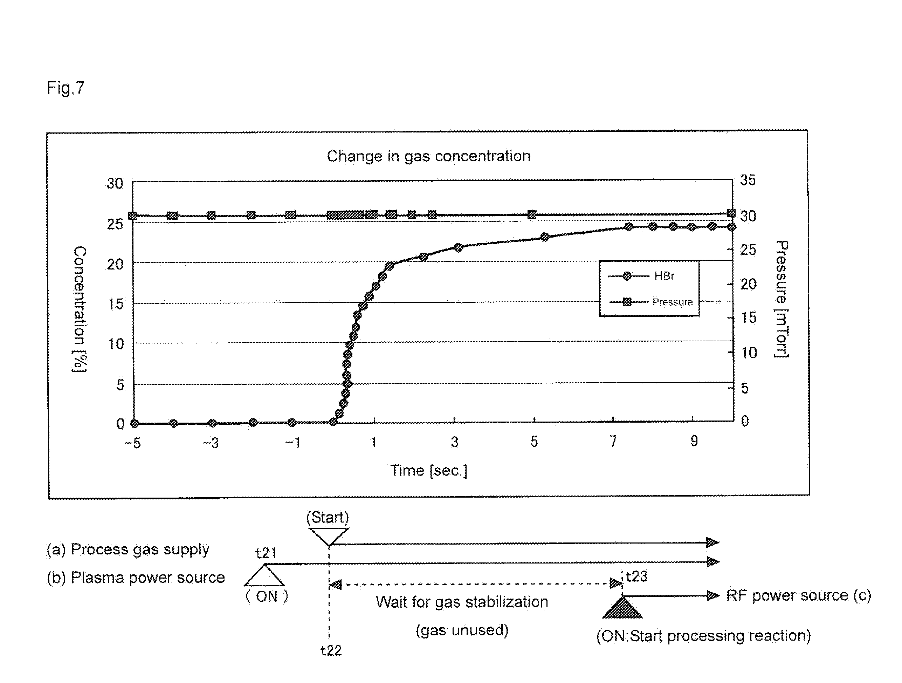

Fig. 7 is a view showing change in gas concentration when using the conventional method.

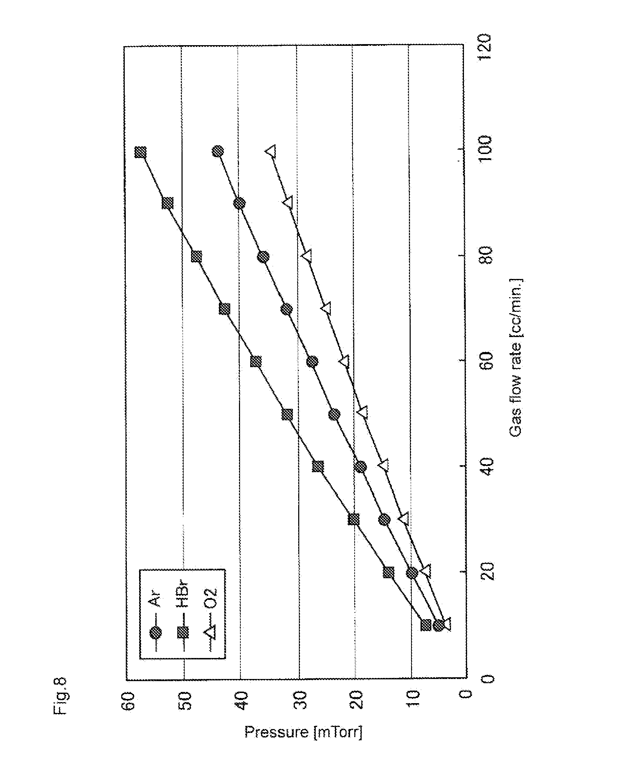

Fig. 8 is a view showing a relationship of the gas flow rate and the pressure in the process chamber for three types of gases.

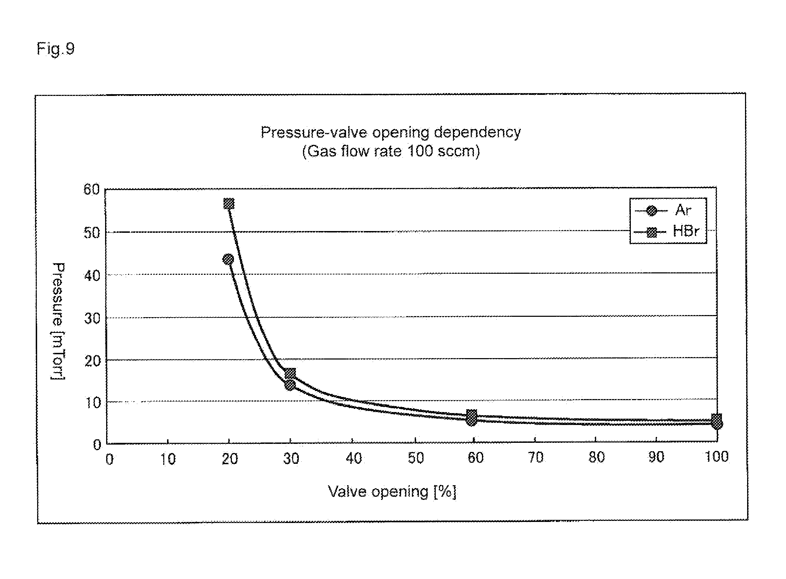

Fig. 9 is a view showing a relationship of the valve opening in the APC and the in-process chamber pressure (gas flow rate 100 sccm).

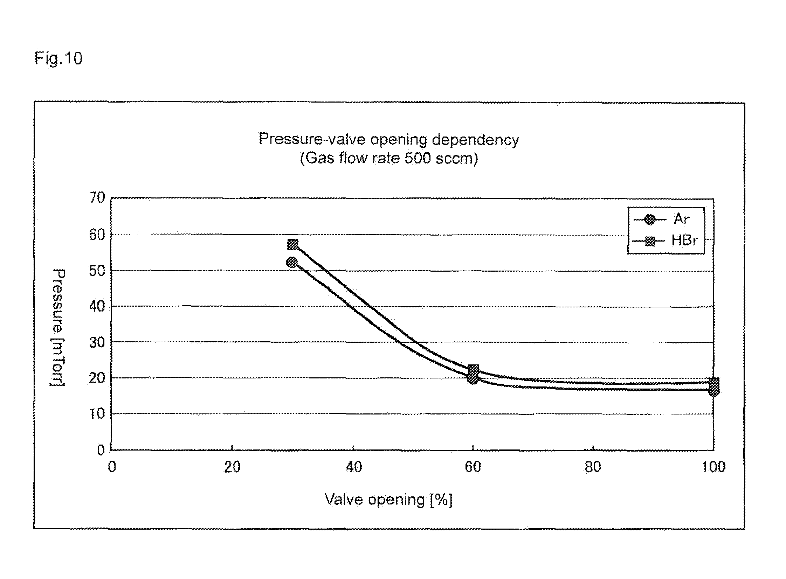

Fig. 10 is a view showing a relationship of the valve opening in the APC and the in-process chamber pressure (gas flow rate 500 sccm).

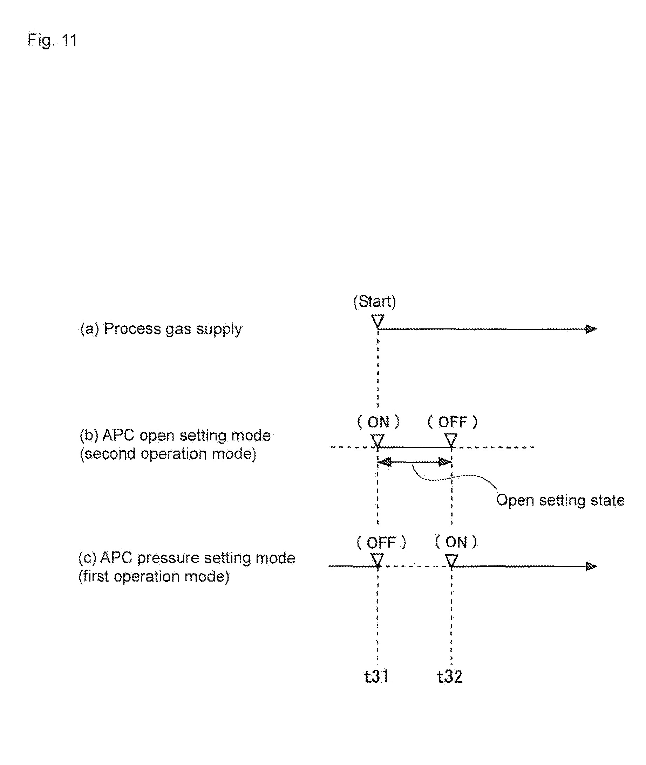

Fig. 11 is a timing chart showing a relationship of the supply of process gas and the operation mode of the APC.

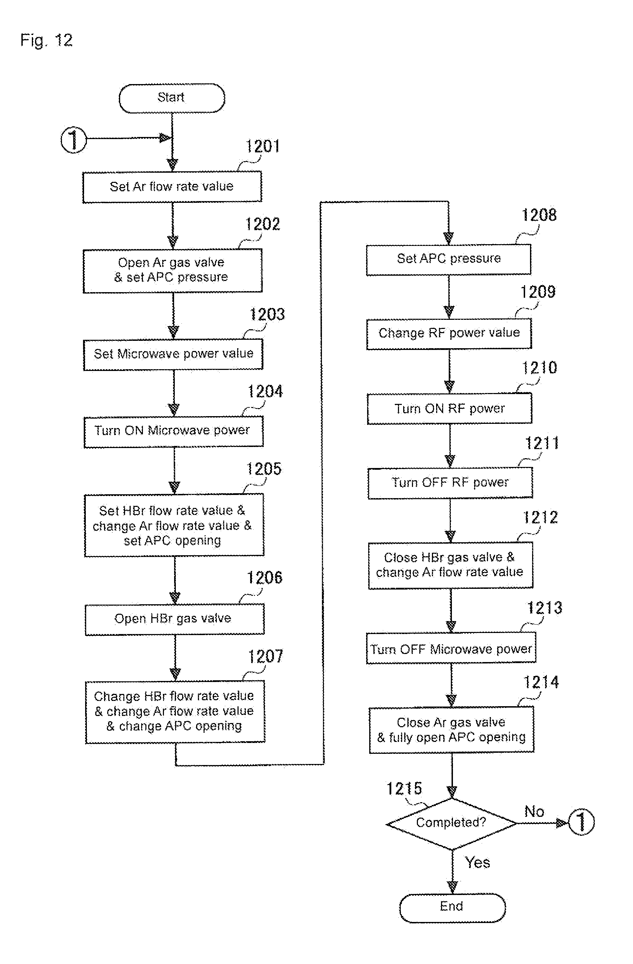

Fig. 12 is a flowchart showing one example of a method for manufacturing an electronic device applied with the present invention.

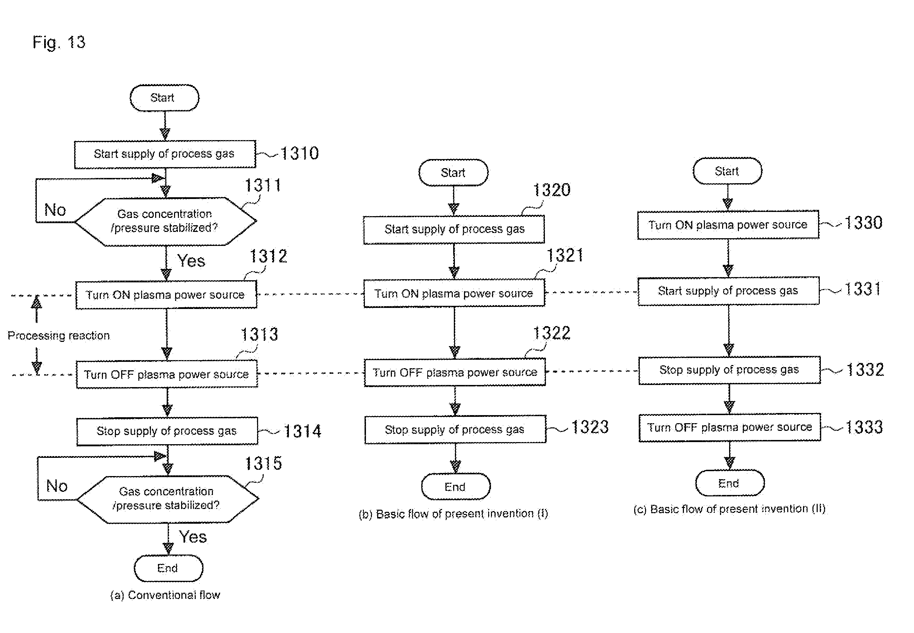

Fig. 13 is a flowchart describing the effects of the present invention.

### DESCRIPTION OF SYMBOLS

- 1: process chamber
- 1a: plasma generator
- 2: first introduction port
- 3: second introduction port
- 4: APC (pressure adjusting device)
- 5: exhaust pump
- 6: microwave power source
- 7: RF power source (13.56 MHz)
- 8: RF power source (2 MHz)
- 9: programmable controller (PLC)
- 9a to 9e: PLC interface
- 10: programmable terminal (PT)
- 11: communication
- MV: manual valve
- FCS: flow control system (pressure control type flow rate adjusting device)
- SV: electromagnetic valve (stop valve)
- 41: control unit
- 42: control valve
- 43: pressure measurement unit
- 51: control unit
- 52: control valve
- 53: pressure measurement unit
- 54: orifice
- 100: plasma reactor processing system

### BEST MODE FOR CARRYING OUT THE INVENTION

One suitable embodiment of a method for manufacturing an electronic device using a plasma reactor processing system according to the present invention will be described in detail below with reference to the accompanied drawings.

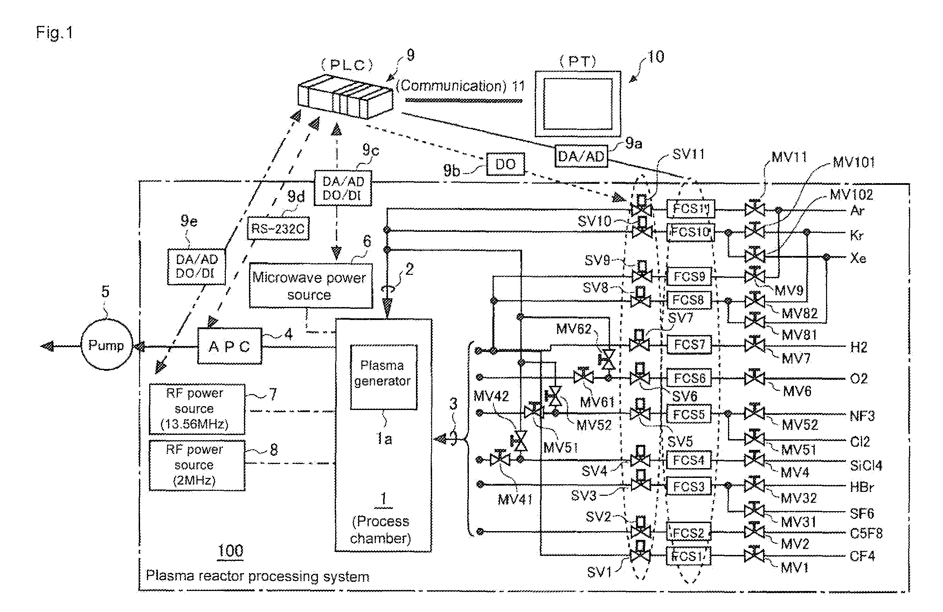

An overall configuration view of the plasma reactor system is shown in Fig. 1. As shown in the figure, a plasma reactor processing system 100 includes a process chamber incorporating a plasma generator 1a, a supply pipe of an inactive gas for connecting each of one type or two or more types of inactive gas source (e.g., Ar, Kr, Xe, etc.) and the process chamber 1; a supply pipe of process gas for connecting each of one type or two or more types of process gas source (e.g., H2, 02, NF3, CL2, SiCl4, HBr, SF6, C5F8, CF4) and the process chamber 1; and an exhaust pipe of the in-chamber gas for connecting the process chamber 1 and an exhaust pump (Pump) 5.

Each of the supply pipe of the inactive gas and the supply pipe of the process gas is interposed with a flow control system (hereinafter referred to as FCS) serving as a pressure control type flow rate adjusting device having a function of automatically changing the opening of a flow rate control valve in a direction of decreasing a deviation between a given flow rate setting value and a flow rate detection value corresponding to a fluid pressure measured through a pressure measurement unit.

More specifically, the supply pipe of Ar gas is branched into a first supply pipe directed to an introduction port 2 to an upper-stage shower plate, and a second supply pipe directed to an introduction port 3 to a lower-stage shower plate. The first supply pipe is interposed with a manual valve MV11, an FCS11, and an electromagnetic valve SV11 serving as a stop valve, and the second supply pipe is interposed with a manual valve MV9, an FCS9, and an electromagnetic valve SV9. Therefore, the flow rate of the Ar gas can be controlled by operating the flow rate setting value of the FCS11 and/or the FCS9.

This is the same for the supply paths of Kr gas and Xe gas. Therefore, the flow rate of the Kr gas and the Xe gas can be controlled by operating the flow rate setting value of an FCS10 and/or an FCS8.

The supply pipe of H2 gas is connected as is to the gas introduction port 3 to the lower-stage shower plate, which pipe is interposed with a manual valve MV7, an FCS7, and an electromagnetic valve SV7. Therefore, the flow rate of the H2 gas can be controlled by operating the flow rate setting value of the FCS7.

This is the same for the supply pipes of HBr gas, SF6 gas, and C5F8 gas. Therefore, the flow rate of the HBr gas, the SF6 gas, and the C5F8 gas can be controlled by operating the flow rate setting value of an FCS2 or an FCS3.

The supply pipe of 02 gas is branched, after passing an electromagnetic valve MV6, an FSC6, and an electromagnetic valve SV6, to a first supply pipe directed to the introduction port 2 to the upper-stage shower plate and a second supply pipe directed to the introduction port 3 to the lower-stage shower plate. The first supply pipe is interposed with a manual valve MV62, and the second supply pipe is interposed with a manual valve MV61. Therefore, the flow rate of the 02 gas can be controlled by operating the flow rate setting value of the FCS6.

This is the same for the NF3 gas, the CL2 gas, and the SiCl4 gas. Therefore, the flow rate of the NF3 gas, the CL2 gas, and the SiCl4 gas can be controlled by operating the flow rate setting value of an FCS5 or an FAS4.

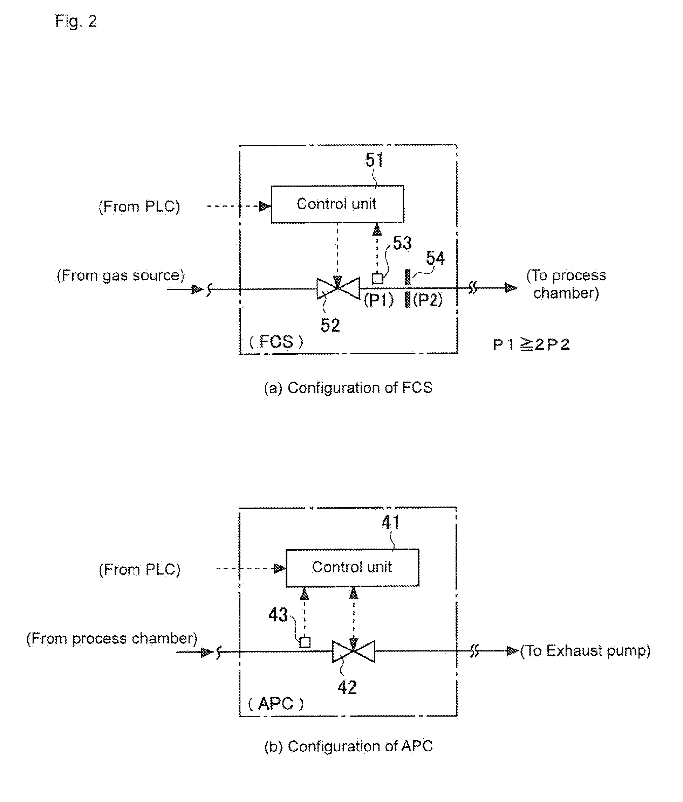

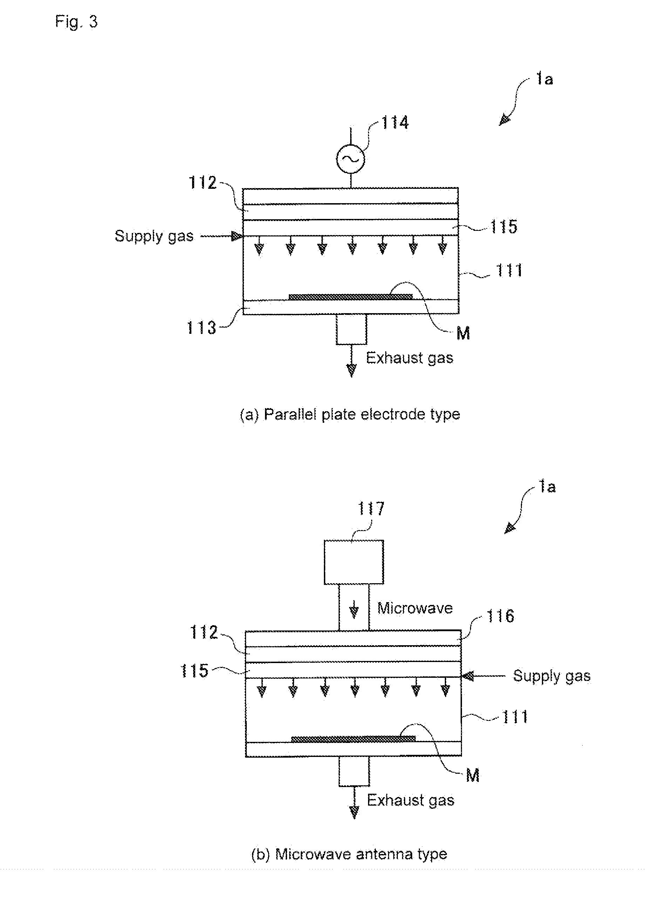

A schematic configuration diagram of the FCS functioning as a pressure control type flow rate adjusting device is shown in Fig. 2(a). As shown in the figure, the FCS includes a control unit 51, a control valve 52, a pressure measurement unit 53, and an orifice 54. Although not shown, the control unit 51 includes an amplifier circuit, a flow rate calculation circuit, a comparison circuit, and a valve drive circuit (see Japanese Unexamined Patent Application No. 2003-203789, Fig. 3). A measurement signal of the pressure measurement unit 53 is amplified by the amplifier circuit, and converted to a corresponding flow rate detection signal in the flow rate calculation circuit. The flow rate detection signal is compared with a flow rate setting signal in the comparison circuit to obtain a deviation signal. The valve drive circuit controls the opening of the control valve 52 in a direction of decreasing the value of such a deviation signal.

The FCS uses the principle that the fluid is a sound speed region if the upstream pressure P1 is larger than or equal to twice the downstream pressure P2, and is proportional to the pressure on the upstream side, where the targeted gas flow rate can be instantly supplied even immediately after the gas supply since the flow rate is controlled by adjusting the upstream pressure P1. For such an FSC having such a function, various products are commercially available from various manufacturing companies such as the model FCS-4WS-798-F3L, model FCS-4WS-798-F500, and model FCS-4WS-798-F1600 manufactured by Fujikin Incorporated, by way of example.

The exhaust pipe of the in-chamber gas is interposed with an auto pressure controller (hereinafter referred to as APC) 4 functioning as a pressure controller having a function of automatically changing the opening of the flow rate control valve in a direction of decreasing the deviation between the given pressure setting value and the pressure measurement value measured through the pressure measurement unit.

A schematic configuration of the APC4 is shown in Fig. 2(b). As shown in the figure, the APC incorporates a control unit 41 and a control valve 42. The control unit 41 has a first operation mode (pressure setting mode) of automatically changing the opening of the control valve 42 in a direction of decreasing the deviation between the given pressure setting value and the pressure measurement value measured through the pressure measurement unit 43 attached to the process chamber decreases, and a second operation mode (open setting mode) of automatically changing the opening of the control valve 42 in a direction of decreasing the deviation between the given open setting value and a current open value. For the APC having such a function, various products are commercially available from various manufacturing companies such as the model control PM-3 and controller valve F61-87665-18 manufactured by VAT SKK VACUUM LTD., by way of example.

A configuration example of the plasma generator is shown in Fig. 3. The plasma generator 1a may be a parallel plate electrode type or a microwave antenna type.

The plasma generator of the parallel plate electrode type is configured by a parallel plate electrode (configured by plasma excitation electrode 112 and electrode 113), RF power sources 7, 8 (see Fig. 1) for supplying high frequency power thereto, a shower plate 115 for supplying process gas and the like, and a chamber 111 for accommodating the above, as shown in Fig. 3(a). The process gas is excited to be in a plasma plate by applying high frequency to the supplied process gas by means of the parallel plate electrode. The plasma generator of the microwave antenna type radiates microwave from a microwave antenna 116 driven by a microwave drive circuit 117 into the chamber 111 to radiate the process gas, instead of using the high frequency power, as shown in Fig. 3(b). In either plasma generator, the generation or stop of plasma can be controlled by turning ON/OFF the plasma power source (RF power sources 7, 8, microwave power source 6, etc.).

Returning to Fig. 1, the control of the FCS1 to FCS11, the electromagnetic valves SV1 to SV11, the APC4, the microwave power source 6, and the RF power sources 7, 8 contained in the plasma reactor processing system is carried out using a programmable controller (hereinafter referred to as PLC) 9 in this example. The PLC 9 is connected to a programmable terminal (hereinafter referred to as PT) 10 functioning as an operation/display unit by way of a communication 11.

I n other words, the PLC 9 and the FCS1 to FCS11 are connected by way of a PLC interface 9a including a DA/AD unit. The PLC 9 and the electromagnetic valves SV1 to SV11 are connected by way of a PLC interface 9b including a DO unit. The PLC 9 and the microwave power source 6 are connected by way of a PLC interface 9c including a DA/AD unit and a DO/DI unit. The PLC 9 and the APC4 are connected by way of a PLC interface 9d including a RS232C. The PLC 9 and the RF power sources 7, 8 are connected by way of a PLC interface 9e including a DA/AD unit and a DO/DI unit. The PLC 9 realizes the manufacturing method of the present invention by executing the process shown in the flowchart of Fig. 11 through the user program.

The concentration changing control, which is the main part of the method for manufacturing the electronic device using the plasma reactor processing system according to the present invention will now be described. The characteristics of the method of the present invention are that in changing the concentration of the process gas, a value obtained by calculating back from the process gas concentration after the estimated change is adopted for the new flow rate setting value to be given to the FCS (pressure control type flow rate adjusting device) interposed in the supply pipe of each constituent gas under the condition that the total flow rate value is identical before and after concentration change.

An explanatory view of the concentration changing control of the present invention is shown in Fig. 4. Assuming the process gas concentration before change of concentration is A1 (e.g., 0%), the process gas supply amount is F11 (e,g., 0 sccm), the inactive gas supply amount is F21 (e.g., 420 sccm), the process gas concentration after change of concentration is A2 (e.g., 24%), the process gas supply amount is F13 (e.g., 100 sccm), and the inactive gas supply amount is F23 (e.g., 320 sccm), a value (F13 = A2 x K, F23 = (1 - A2) x K) obtained by back calculating from the process gas concentration (A2) after the estimated change is adopted for the new flow rate setting value (F13, F23) given to the FCS (pressure control type flow rate adjusting device) interposed in the supply pipe of each constituent gas under the condition that the total flow rate value is identical (F1 + F21 = F13 + F23 = K) before and after concentration change in the concentration changing control of the present invention.

If the flow rate setting value (F13, F23) obtained in such a manner is provided to each FCS, the total flow rate in the chamber does not increase, in principle, at before and after concentration change, and thus the pressure in the process chamber does not greatly fluctuate (increase) in concentration change, and the in-chamber pressure should instantly stabilize.

However, if such a method is uniformity adopted, quite a long period is required until reaching the target process gas concentration and consequent the start of process delays when the flow is difficult due to gas type or capacity of process chamber is large as the flow rate fluctuation width of each gas at before and after concentration change is limited.

In this example, limiting to a predetermined short period (Δt) from the modification start, the new flow rate setting value of each constituent gas is added with the exceeding amount (-ΔF) in the decreasing direction for the constituent gas that decreases after change and the exceeding amount (+ΔF) in the increasing direction for the constituent gas that increases after change, and the total exceeding amount in the decreasing direction and the total exceeding amount in the increasing direction are set to be identical with each other.

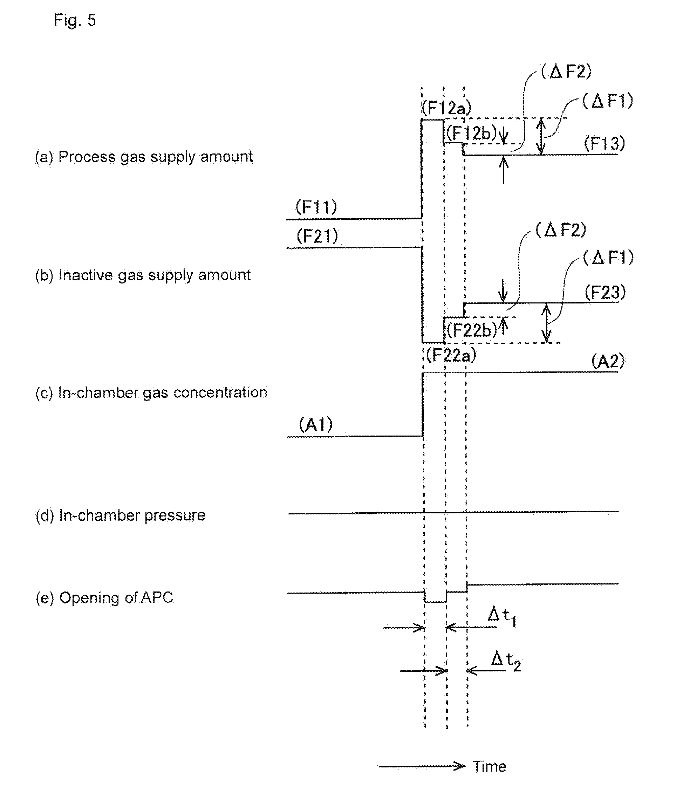

The exceeding amount can be realized with a plurality of pulses as long as the condition is met that the total exceeding amount in the decreasing direction and the total exceeding amount in the increasing direction are identical with each other. As one example of a plurality of pulses, an explanatory view of when the exceeding amount is two pulses is shown in Fig. 5. In the figure, the new flow rate setting value of the individual constituent gas is first added, limiting to a predetermined short period (Δt1) from the modification start, with the exceeding amount (-ΔF1) in the decreasing direction for the constituent gas that decreases after change and the exceeding amount (+ΔF1) in the increasing direction for the constituent gas that increases after change, and the total exceeding amount in the decreasing direction and the total exceeding amount in the increasing direction are set to be identical with each other. Furthermore, even in the following predetermined short period (Δt2), the exceeding amount (-ΔF2) in the decreasing direction is added for the constituent gas that decreases after change and the exceeding amount (+ΔF2) in the increasing direction is added for the constituent gas that increases after change, and the total exceeding amount in the decreasing direction and the total exceeding amount in the increasing direction are set to be identical with each other.

According to such an exceeding amount addition method, limiting to the predetermined short period (Δt) from the start of modification of the concentration, a large flow rate fluctuation occurs for the individual gas type while maintaining the total flow rate constant, and thus the period until reaching the target process gas concentration can be reduced. Here, (e) in Fig. 5 shows the opening of the APC in the short period. The predetermined short period (Δt) is suitably shorter than or equal to two seconds, although depending on the type of gas.

The control result by the concentration changing control (see Fig. 4) of the present invention and the control result by the conventional concentration changing control will now be described using a specific plasma reactor processing system by way of example. A poly-Si film is etched through plasma excitation etching using the plasma generator (see Fig. 3(b)) of microwave type. The chamber capacity is 53 liters, the in-chamber gas flow rate is total 420 cc/min., the gas type is HBr for the process gas type, and the plasma excitation gas is Ar or inactive gas. The concentration ratio of HBr and Ar in a steady state is targeted as 24% and 76%, respectively. The in-process chamber target pressure is 30 mTorr, the plasma generation microwave is 2.45 GHz, the self-bias voltage high frequency is 13.56 MHz, the substrate temperature is 20°C, and the process processing reaction period is 30 seconds.

The change in gas concentration of when using the concentration changing control (see Fig. 4) of the present invention is shown in Fig. 6, and the change in gas concentration of when using the conventional concentration changing control is shown in Fig. 7.

As shown in Fig. 7, when the conventional concentration changing control is used, if the plasma power source is turned ON at time t21 and then the supply of process gas is started at time t22, it takes about seven seconds until time t23 at which the concentration of the process gas stabilizes. Therefore, in the conventional example, a waiting period (about seven seconds) for the gas concentration and the pressure to stabilize is required until turning ON the RF source and starting the processing reaction after the start of supply of the process gas. The process gas supplied during the waiting period is not used at all for the processing reaction, and is exhausted from the process chamber and thus becomes a waste.

As shown in Fig. 6, when the concentration changing control of the present invention is used, if the plasma power source is turned ON at time t11, and then the supply of process gas is started at time t12, it only takes about one second until time t13 at which the concentration of the process gas stabilizes. Therefore, only about one second is enough for the waiting period for the gas concentration and the pressure to stabilize until turning ON the RF power source and starting the processing reaction after the start of supply of the process gas. The stabilization period has a shortness of an extent the etching due to the transient state of the process gas concentration or the irregularity of the formed film falls within a tolerable range according to the purpose of the process. The turning ON of the RF power source and the start of supply of the process gas may be carried out substantially at the same time (e.g., RF turned ON between start of change to stabilization of process gas concentration, etc.).

Therefore, the processing reaction period is 30 seconds and the waiting period of the start of the processing reaction is a high ratio or seven seconds in the conventional method, whereas the waiting period is shorter than or equal to one second and thus the processing period is significantly reduced, and the process gas can be effectively utilized since the process gas supplied during the waiting period is unnecessary in the method of the present invention.

In the above example, the gas switching is performed from the argon gas (Ar), which is the inactive gas, to the mixed gas (Ar/HBr: 76 to 24) of the inactive gas and the process gas, and the poly-Si etching process is started, but it should be recognized that this is merely an example of the present invention.

In other words, the concentration changing control of the present invention can also be applied to a case where the switching from the process gas (A) to the process gas (B) is performed while the plasma power source is turned ON. If the process gas is switched during plasma generation, a plurality of types of films of different types can be stacked and formed on a substrate to be processed. The plurality of types of films of different types then can be etched by applying self-bias voltage.

As shown in Fig. 8, a difference is seen in the in-chamber pressure when plural gas types (Ar, HBr, 02) exist in the chamber although the flow rate is the same in the respective gas. This is caused by the difference in easiness in flow of the gas depending on the gas type, or the difference in easiness in flowing of the exhaust air to the pump. The difference creates in the in-chamber pressure if the gas type is different although the gas flow rate is the same, and thus the difference creates in the in-chamber pressure if the gas ratio is different although the total flow rate is the same in the mixed gas. Therefore, to have the pressure constant when the gas type or the gas ratio is changed, the pressure control by the APC 4 is necessary even if the total flow rate is constant.

In other words, even if a value obtained by calculating back from the process gas concentration after the estimated change is adopted for the new flow rate setting value given to the FCS (pressure control type flow rate adjusting device) interposed in the supply pipe of each constituent gas under the condition that the total flow rate value is identical before and after concentration change, the pressure fluctuation may still occur in the process chamber due to the difference in easiness in flow or the difference in easiness in exhaustion for every gas type.

In such a case, the APC 4 (see Fig. 1) interposed in the exhaust pipe is switched from the first operation mode (pressure setting mode) to the second operation mode (valve open setting mode) limited to the predetermined short period from the modification start, and the valve open setting value obtained experimentally is given to mitigate the pressure fluctuation immediately after the change, and thus the pressure fluctuation originating from the gas type is immediately mitigated by having the valve opening instantly following thereto. The switch from the first operation mode to the second operation mode is adopted as the second operation mode (value open setting mode) can reach the target valve opening in a short period relative to the first operation mode (pressure setting mode).

As shown in Fig. 9 and Fig. 10, a certain relationship is found with the in-chamber gas flow rate as a parameter between the opening of the control valve incorporated in the APC 4 and the in-chamber pressure. The valve open setting value required to mitigate the pressure fluctuation immediately after concentration change can be obtained by repeating the experiment based on such a relationship, and the obtained valve open setting value is given to the APC 4 after switching from the first operation mode to the second operation mode.

More specifically, as shown in Fig. 11, at time t31, the supply of process gas is started (change in concentration) and the operation mode of the APC 4 is switched from the first operation mode (pressure setting mode) to the second operation mode (valve open setting mode), and at the same time, the valve open setting value obtained experimentally is given to the APC 4 to mitigate the pressure fluctuation immediately after the change.

The pressure fluctuation upon concentration change due to difference in gas type and the like is then instantly and forcibly stabilized by the second operation mode (valve open setting mode) without waiting for the gradual stabilization by the first operation mode (pressure setting mode).

Through the simultaneous use of the control by the second operation mode (valve open setting mode), the control of having the new flow rate setting value given to the FCS (pressure control type flow rate adjusting device) of each constituent gas as the value obtained by back calculating from the process gas concentration after the estimated change under the condition that the total flow rate value is identical before and after concentration change does not need to taken into consideration the difference in gas type, and the complication of the control can be avoided by that much. During the period until returning to the first operation mode (time t32) after switched from the first operation mode to the second operation mode (time t31), that is, the short period of switching from the first operation mode to the second operation mode is appropriately shorter than or equal to three seconds, although this depends on the type of gas. This switching may be performed simultaneously with the changing of the gas flow rate value or may be performed at a different timing.

A flowchart showing one example of a manufacturing method (include controls of Fig. 4 and Fig. 11) applied with the present invention is shown in Fig. 12. in this example, the inactive gas is Ar and the process gas is HBr. The series of processes shown in the flowchart can be realized in the PLC 9.

First, in step 1201, the Ar flow rate is set on the PCS of the Ar gas. In the following step 1202, the opening of the Ar gas valve (electromagnetic valve interposed on the secondary side of the FCS of the Ar gas) and the pressure setting on the APC (pressure setting in the first operation mode) are simultaneously performed. The Ar gas is then introduced into the chamber, and the pressure thereof is stabilized at a predetermined pressure by the action of the first operation mode (pressure setting mode) of the APC.

In the following step 1203, the microwave power value is set on the microwave power source 6. In the following step 1204, the microwave power ON is performed (microwave power source is turned ON).

In the following step 1205, the setting of the HBr flow rate value (F12 including exceeding amount ΔF of Fig. 4) on the FCS of the HBr gas, the changing of the flow rate value (F22 including exceeding amount ΔF of Fig. 4) of the Ar gas, and the open setting (open setting in the second mode) of the APC are simultaneously performed. In the following step 1206, the HBr gas valve (electromagnetic valve interposed on the secondary side of the FCS of the HBr gas) is opened.

In the following step 1207, the HBr flow rate value change (F13 of Fig. 4) and the Ar flow rate value change (F23 of Fig. 4) are simultaneously performed. The open setting of the APC is performed as necessary, The step 1207 is executed over plural times as shown in Fig. 5, as needed. In the following step 1208, the APC pressure (pressure setting in the first mode) is set. In the following step 1209, the RF power value is set on the RF power sources 7, 8 (setting of the RF power on the lower electrode). In the following step 1210, the RF power ON is performed. The preparation to start the process is thereby completed. Thereafter, the RF power value is changed in accordance with the processing content, and the semiconductor manufacturing process, the liquid crystal manufacturing process, or the like is performed.

After the process is completed, the RF power OFF is performed in the following step 1211, the closing of the HBr gas valve and the changing of the Ar flow rate are performed in step 1212, and the microwave power OFF is performed in the following step 1213. In the following step 1214, the closing of the Ar gas valve and the full-opening of the APC opening are performed.

As long as the series of manufacturing steps continue (NO in step 1215), the processes of step 1201 to step 1214 are repeatedly executed while switching the process gas (gas corresponding to HBr in Fig. 12) used according to the process. After the series of manufacturing steps is terminated (YES in step 1215), the process is terminated. According to the embodiment of the present invention, different processing can be continuously performed without stopping the reaction in the middle when switching the process gas, and thus the period of the entire process can be reduced.

As described above, the manufacturing method including the concentration changing process of the present invention can be realized by appropriately controlling the FCS1 to FCS11, the electromagnetic valves SV1 to SV11, the APC4, the microwave power source 6, the RF power sources 7, 8, and the like using the PLC 9.

Finally, a flowchart for describing the effects of the present invention in comparison to the conventional example is shown in Fig. 13.

As shown in Fig. 13(a), in the conventional manufacturing method, after the start of supply of process gas (switch from inactive gas to process gas) (step 1310), the concentration and the pressure of the process gas in the process chamber are waited until stabilized at target values (step 1311), and then the plasma power source is turned ON to start the processing reaction (step 1312). At the termination of the processing reaction, the plasma power source is turned OFF to terminate the processing reaction (step 1313), and then the supply of process gas is stopped (switch from process gas to inactive gas) (step 1314), and the process for the next step (e.g., open the door of the process chamber to take out the substrate etc.) is not performed until the gas concentration and the pressure in the process chamber stabilize at the target values (step 1315). In this case, the period for waiting the gas concentration and the pressure in the chamber to stabilize becomes a wasteful period in which no process is performed.

In the present invention, on the other hand, as shown in Fig. 13(b), the start of supply of the process gas (step 1320) and the turning ON of the plasma power source (step 1321) may be performed at substantially the same time, and similarly, the turning OFF of the plasma power source (step 1322) and the stop of supply of the process gas (step 1312) may be performed at substantially the same time. As opposed to the prior art, this is possible because the gas concentration reaches to and stabilizes at the target value instantly in the process chamber 1, and the process processing can be executed from the moment the gas is supplied. The process gas may be a mixed gas of the material gas (gas that becomes the material of film and the like to be generated by the process) and the inactive gas, or may be only the material gas.

As shown in Fig. 13(c), in the present invention, the supply of process gas is started (switch from inactive gas to process gas) (step 1331) after the plasma power source is turned ON (step 1330) in the process chamber. At the termination of the process, the supply of the process gas is stopped (switch from process gas to inactive gas) (step 1332), and then the plasma power source is turned OFF (step 1333), As opposed to the prior art, this is possible because the gas concentration reaches to and stabilizes at the target value instantly in the process chamber 1, and the process processing can be executed from the moment the gas is supplied.

In this case, the start of supply of the process gas (switch from inactive gas to process gas) and the turning ON of the plasma power source may be performed at substantially the same time, and similarly, the stop of supply of the process gas (switch from process gas to inactive gas) and the turning OFF of the plasma power source may be performed at substantially the same time. The process gas may be a mixed gas of the material gas (gas that becomes the material of film and the like to be generated by the process) and the inactive gas, or may be only the material gas.

### INDUSTRIAL APPLICABILITY

According to the present invention, the process gas introduced into the reactor is immediately plasmatized to contribute to the plasma reaction process, whereby the utilization efficiency of the process gas enhances and the manufacturing cost lowers by that much. In addition, the productivity also enhances due to reduction in the TAT (Turn-Around time) of the process as the waiting period before the start of the reaction process can be greatly reduced.

With the completion of the plasma reaction, the supply of process gas is immediately stopped, and thereafter, a plasma generation stop command can be rapidly provided to the plasma generator, thereby preventing the process gas not contributing to the plasma reaction from being wastefully used and lowering the manufacturing cost through enhancement of the utilization efficiency of the process gas.

The productivity also enhances due to reduction in the TAT (Turn-Around time) of the process as the waiting period after the termination of the reaction process can be greatly reduced.

In addition to the supplied process gas immediately contributing to the plasma reaction process, the power is not wastefully consumed at the start of the plasma reaction process, whereby the productivity enhances and the process gas can be saved, and in addition, lower cost can be pursued to the maximum by saving power energy.

Moreover, as the supply of process gas is also stopped with the cutting of the power and the termination of the plasma reaction process, the process gas is not wasteful consumed, whereby the productivity enhances and the process gas can be saved, and in addition, lower cost can be pursued to the maximum by saving power energy.

The method for manufacturing the electronic device using the plasma reactor processing system of the present invention can be applied to a plasma reaction process of a substrate (plasma oxidation process, plasma nitriding process, plasma CVD process, plasma etching process, plasma ashing process etc.) and plasma cleaning process of in-chamber wall and the like in the manufacturing of a semiconductor device, a solar battery, a large plane display device (liquid crystal display device, organic EL display device, etc.), and other electronic devices. In other words, the method of the present invention is suitably used in the manufacturing of a general electronic device.

## Claims

1. A method for manufacturing an electronic device using a plasma reactor processing system inducing:
a process chamber incorporating a plasma generator;
a supply pipe of an inactive gas for connecting each of one type or two or more types of inactive gas source and the process chamber;
a supply pipe of a process gas for connecting each of one type or two or more types of process gas source and the process chamber; and
an exhaust pipe of an in-chamber gas for connecting the process chamber and an exhaust pump,
each of the supply pipe of the inactive gas and the supple pipe of the process gas being interposed with a pressure control type flow rate adjusting device having a function of automatically changing an opening of a flow rate control valve in a direction of decreasing a deviation between a given flow rate setting value and a flow rate detection value corresponding to a fluid pressure measured through a pressure measurement unit; and
the exhaust pipe of the in-chamber gas being interposed with a pressure controller having a first operation mode of automatically changing the opening of the flow rate control valve in a direction of decreasing a deviation between a given pressure setting value and a pressure measurement value; the method comprising:
the first step of giving a new flow rate setting value to each of the pressure control type flow rate adjusting device interposed on the supply pipe of each constituent gas for changing a concentration of the process gas in the process chamber; wherein
in the first step, each new flow rate setting value given to each of the flow rate adjusting device is a value obtained by calculating back from a process gas concentration after an estimated change under a condition that a total flow rate value is identical with each other between before and after the change in concentration.

2. The method for manufacturing the electronic device using the plasma reactor processing system according to claim 1, wherein
in the first step, limiting to a predetermined first period from start of change, each of the new flow rate setting value given to each of the flow rate adjusting device is added with an exceeding amount in a decreasing direction for a constituent gas that decreases after the change and an exceeding amount in an increasing direction for a constituent gas that increases after the change, and a total exceeding amount in the decreasing direction and a total exceeding amount in the increasing direction are set to be identical with each other.

3. The method for manufacturing the electronic device using the plasma reactor processing system according to claim 2, wherein the first period is smaller than or equal to two seconds.

4. The method for manufacturing the electronic device using the plasma reactor processing system according to claim 1 or 2, wherein
the pressure controller interposed in the exhaust pipe of the in-chamber gas further has a second operation mode of automatically changing the opening of the flow rate control valve in a direction of decreasing a deviation between an open setting value and a current open value, and the method further includes:
the second step of, limiting to a predetermined second period from the start of the change, switching the pressure controller interposed in the exhaust pipe from the first operation mode to the second operation mode, and giving a valve open setting value obtained experimentally to mitigate a pressure fluctuation immediately after the change.

5. The method for manufacturing the electronic device using the plasma reactor processing system according to claim 4, wherein the second period is smaller than or equal to three seconds.

6. The method for manufacturing the electronic device using the plasma reactor processing system according to any one of claims 1 to 5, wherein the change in concentration of the process gas includes the change in concentration of the process gas at the start of the process, in the middle of the process, or at the end of the process.
